# EUROPÄISCHE PATENTSCHRIFT

(11) **EP 1 906 534 B1**
(45) Veröffentlichungstag und Bekanntmachung des Hinweises auf die Patenterteilung: **12.01.2011**
(21) Anmeldenummer: 06405407.5
(22) Anmeldetag: 28.09.2006
(51) Int. Cl.: H03K 19/0175

(54) **Verfahren zum Bestimmen einer Einschaltschwelle und elektronische Schaltungsanordnung zur Durchführung des Verfahrens**
Method for determining a switching threshold and associated circuit .
Procédé pour déterminer un seuil de commutation et circuit associé.

(43) Veröffentlichungstag der Anmeldung: 02.04.2008
(73) Patentinhaber: ABB Technology AG, 8050 Zürich (CH)
(72) Erfinder: Schilling, Robert, 5443 Niederrohrdorf (CH)
(74) Vertreter: ABB Patent Attorneys

(56) Entgegenhaltungen:
- EP-A1- 0 461 627
- US-A- 4 523 143
- US-A1- 2002 083 352
- US-B1- 6 420 910

## Beschreibung

### TECHNISCHES GEBIET

Die vorliegende Erfindung betrifft allgemein elektronische Schaltungsanordnungen zur Konvertierung von Eingangssignalen in Ausgangssignale, und betrifft insbesondere eine elektronische Schaltungsanordnung, in die ein digitales Eingangssignal eingegeben wird, das bei Erreichen einer bestimmten Schaltschwelle ein digitales Ausgangssignal umschaltet.

Spezifisch betrifft die vorliegende Erfindung eine elektronische Schaltungsanordnung zur Konvertierung eines Eingangsspannungssignals eines ersten Spannungspegels in ein Ausgangsspannungssignal eines zweiten Spannungspegels, wobei eine Eingabeeinheit zum Eingeben des Eingangsspannungssignals bei dem ersten Spannungspegel, eine Schwellwertvergleichseinheit zum Vergleichen des ersten Spannungspegels des Eingangssignals mit einem Einschaltschwellwert und eine Ausgabeeinheit zur Ausgabe des Ausgangssignals in Abhängigkeit von dem Vergleich des ersten Spannungspegels des Eingangsspannungssignals mit dem Einschaltschwellwert vorgesehen sind.

### STAND DER TECHNIK

Es sind elektronische Schaltungsanordnungen zur Konvertierung eines Eingangsspannungssignals eines ersten Spannungspegels in einem Ausgangsspannungssignal eines zweiten Spannungspegels bekannt. Derartige herkömmliche elektronische Schaltungsanordnungen erlauben es, Eingangsspannungssignale, die einen breiten Eingangsspannungsbereich von beispielsweise 80 V bis 300 V aufweisen, in entsprechende Ausgangsspannungssignale zu konvertieren. Damit die elektronische Schaltungsanordnung Spannungssignale eines derart breiten Eingangsspannungsbereichs verarbeiten kann, muss der Eingang der elektronischen Schaltungsanordnung einen hochohmigen Eingang aufweisen, d. h. die elektronische Schaltungsanordnung muss eine hohe Eingangsimpedanz gegenüber dem zu verarbeitenden bzw. zu verstärkenden Eingangsspannungssignal aufweisen.

Die im Stand der Technik vorgeschlagene Lösung zur Verarbeitung von Eingangsspannungssignalen in einem breiten Eingangsspannungsbereich weist jedoch zahlreiche Nachteile auf. Ein wesentlicher Nachteil herkömmlicher Schaltungsanordnungen besteht darin, dass hohe Eingangsimpedanzen zu einer großen Störanfälligkeit der Schaltungsanordnung führen. Hochohmige Eingänge sind insbesondere gegenüber einem Übersprechen zwischen Kanälen, Kreuzmodulationseffekten, einem Rauschen und einer Einstreuung von elektrischen und magnetischen Feldern äußerst empfindlich.

In vielen Fällen ist es jedoch unbedingt notwendig, einen Wechsel in einem Pegel eines zu verarbeitenden Eingangsspannungssignals störungsfrei zu erkennen, beispielsweise dann, wenn ein Einschaltzeitpunkt genau zu erfassen ist. Dies ist insbesondere bei der Erfassung digitaler bzw. binärer Signale von großer Bedeutung. Auch derartige digitale bzw. binäre Signale können bei verschiedenen Anwendungen einen großen Eingangsspannungsbereich aufweisen, wie er obenstehend spezifiziert ist.

Um die Störsicherheit herkömmlicher elektronischer Schaltungsanordnungen zu verbessern, ist im Stand der Technik vorgeschlagen worden, die Eingangsimpedanz derartiger elektronischer Schaltungsanordnungen zu verringern. Dies führt in unzweckmäßiger Weise bei den betrachteten Eingangsspannungsbereichen (80 V - 300 V) zu hohen Strömen und damit zu hohen Verlustleistungen. Durch die Verringerung der Eingangsimpedanz wird zwar die Empfindlichkeit auf die oben genannten Störungen, wie beispielsweise ein Übersprechen, eine Kreuzmodulation, Rauschanteile, eine Einstreuung von elektrischen oder magnetischen Feldern und die Problematik, die mit der elektromagnetischen Verträglichkeit verbunden ist, etwas abgemildert, für viele Anwendungen ist jedoch die Zunahme der Verlustleistung infolge des in der geringeren Eingangsimpedanz erhöhten Eingangsstroms nicht tolerierbar

US 4 523 143 offenbart eine Schaltsanordnung zur Prüfung von Signalen. Ein Pegelschieber wird zur Unterstützung verwendet, um eine ausreichende Spannung am Ausgang der Schaltung zu erhalten. Eine Eingangsimpedanz wird manuell geschaltet und basiert auf dem Pegel des getesteten Signals.

US 2002/0083352 offenbart einen Pegelschieber, der jeweils einen Pegelschieber mit niedrigem Leistungsverbrauch und mit breitem Arbeitsbereich enthält, wobei einer dieser Pegelschieber nach einer kurzen Verzögerung und in Abhängigkeit vom Pegel des Eingangssignales ausgewählt wird

### DARSTELLUNG DER ERFINDUNG

Es ist daher eine Aufgabe der vorliegenden Erfindung, eine elektronische Schaltungsanordnung zur Konvertierung eines Eingangsspannungssignals in ein Ausgangsspannungssignal für einen großen Eingangsspannungsbereich bereitzustellen, welche unempfindlich gegenüber Störungen des Eingangsspannungssignals ist.

Diese Aufgabe wird erfindungsgemäß durch eine elektronische Schaltungsanordnung zur Konvertierung eines Eingangsspannungssignals eines ersten Spannungspegels in ein Ausgangssignal eines zweiten Spannungspegels mit den Merkmalen des Patentanspruchs 1 gelöst. Ferner wird die Aufgabe durch ein im Patentanspruch 7 angegebenes Verfahren gelöst.

Weitere Ausgestaltungen der Erfindung ergeben sich aus den Unteransprüchen.

Ein wesentlicher Gedanke der Erfindung besteht darin, die Eingangsimpedanz einer elektronischen Schaltungsanordnung derart umzuschalten, dass ein Einschaltzeitpunkt störungsfrei erfasst werden kann und dass gleichzeitig eine hohe Verlustleistung durch einen übermäßig hohen Eingangsstrom vermieden wird. Ein übermäßig hoher Eingangsstrom wird dadurch vermieden, dass die Eingangsimpedanz zu einem weiteren Zeitpunkt, der um eine Verzögerungszeitdauer nach dem Einschaltzeitpunkt liegt, umgeschaltet wird.

Somit ist es vorteilhaft, dass zu dem Einschaltzeitpunkt eine niedrige Eingangsimpedanz der elektronischen Schaltungsanordnung bereitgestellt werden kann, während zu einem späteren

Zeitpunkt, d. h. nach einem zuverlässigen und durch Störungen nicht beeinflussten Einschalten eine hohe Eingangsimpedanz in die elektronische Schaltungsanordnung bereitgestellt werden kann, so dass nach einem zuverlässigen Einschalten ein Eingangsstrom nicht übermäßig ansteigt und damit eine Erhöhung einer Verlustleistung vermieden werden kann.

Die erfindungsgemäße elektronische Schaltungsanordnung zur Konvertierung eines Eingangsspannungssignals eines ersten Spannungspegels in ein Ausgangssignal eines zweiten Spannungspegels weist im Wesentlichen auf:
a) eine Eingabeeinheit zum Eingeben des Eingangsspannungssignals bei dem ersten Spannungspegel;
b) eine Schwellwertvergleichseinheit zum Vergleichen des ersten Spannungspegels des Eingangsspannungssignals mit einem Einschaltschwellwert; und
c) eine Ausgabeeinheit zur Ausgabe des Ausgangssignals in Abhängigkeit von dem Vergleich des ersten Spannungspegels des Eingangsspannungssignals mit dem Einschaltschwellwert,
d) wobei eine Eingangsimpedanz-Umschalteinheit zur Umschaltung einer Eingangsimpedanz der Schaltungsanordnung von einem niedrigen Wert auf einen hohen Wert nach einer vorbestimmten Verzögerungszeitdauer (411) nach einem Zeitpunkt (410), zu welchem der erste Spannungspegel des Eingangsspannungssignals (101) den Einschaltschwellwert (404) überschritten hat, bereitgestellt ist.

Ferner weist das erfindungsgemäße Verfahren zum Konvertieren eines Eingangsspannungssignals eines ersten Spannungspegels in ein Ausgangssignal eines zweiten Spannungspegels im Wesentlichen die folgenden Schritte auf:
a) Eingeben des Eingangsspannungssignals bei dem ersten Spannungspegel mittels einer Eingabeeinheit;
b) Vergleichen des ersten Spannungspegels des Eingangsspannungssignals mit einem Einschaltschwellwert mittels einer Schwellwertvergleichseinheit; und
c) Ausgeben des Ausgangssignals in Abhängigkeit von dem Vergleich des ersten Spannungspegels des Eingangsspannungssignals mit dem Einschaltschwellwert mittels einer Ausgabeeinheit,
d) wobei eine Eingangsimpedanz der Schaltungsanordnung von einem niedrigen Wert auf einen hohen Wert nach einer vorbestimmten Verzögerungszeitdauer (411) nach einem Zeitpunkt (410), zu welchem der erste Spannungspegel des Eingangsspannungssignals (101) den Einschaltschwellwert (404) überschritten hat, umgeschaltet wird.

In den Unteransprüchen finden sich vorteilhafte Weiterbildungen und Verbesserungen des jeweiligen Gegenstandes der Erfindung.

Gemäß einer bevorzugten Weiterbildung der vorliegenden Erfindung ist eine Auslöseeinheit bereitgestellt, die ein Umschaltsignal zur Umschaltung der Eingangsimpedanz der Schaltungsanordnung von einem niedrigen Wert auf einen hohen Wert, wenn der erste Spannungspegel des Eingangsspannungssignals den Einschaltschwellwert überschreitet, nach einer vorbestimmten Verzögerungszeitdauer der Eingangsimpedanz-Umschalteinheit zuführt.

Gemäß einer weiteren bevorzugten Weiterbildung der vorliegenden Erfindung sind eine primärseitige Schaltungseinrichtung und eine sekundärseitige Schaltungsvorrichtung bereitgestellt, welche über eine Kopplereinrichtung gekoppelt sind. Die primärseitige Schaltungseinrichtung enthält hierbei die Eingangsimpedanz-Umschalteinheit zur Umschaltung der Eingangsimpedanz der Schaltungsanordnung. Vorzugsweise ist die Kopplereinrichtung als ein magnetischer Koppler ausgebildet. In bevorzugterer Weise ist die Kopplereinrichtung als ein Optokoppler ausgebildet.

Gemäß noch einer weiteren bevorzugten Weiterbildung der vorliegenden Erfindung weist die Schwellwertvergleichseinheit eine Schaltungshysterese derart auf, dass ein Ausschaltschwellwert spannungsmäßig unterhalb einem Einschaltschwellwert liegt.

Gemäß noch einer weiteren bevorzugten Weiterbildung der vorliegenden Erfindung weist die Eingangsimpedanz der Schaltungsanordnung einen niedrigen Wert auf, solange der erste Spannungspegel des Eingangsspannungssignals kleiner als der Einschaltschwellwert ist. In zweckmäßiger Weise weist die Eingangsimpedanz der Schaltungsanordnung einen hohen Wert auf, wenn der erste Spannungspegel des Eingangsspannungssignals den Einschaltschwellwert überschreitet.

Gemäß noch einer weiteren bevorzugten Weiterbildung der vorliegenden Erfindung schaltet die Eingangsimpedanz-Umschalteinheit die Eingangsimpedanz der Schaltungsanordnung von einem niedrigen Wert auf einen hohen Wert zu einem Einschaltzeitpunkt, wenn der erste Spannungspegel des Eingangsspannungssignals den Einschaltschwellwert überschreitet, um.

In bevorzugter Weise wird die Eingangsimpedanz der Schaltungsanordnung von einem hohen Wert auf einen niedrigen Wert zu einem Umschaltzeitpunkt, nach einem Verstreichen einer Verzögerungszeitdauer nach dem Einschaltzeitpunkt, wenn der erste Spannungspegel des Eingangsspannungssignals den Einschaltschwellwert überschritten hat, umgeschaltet.

Gemäß noch einer weiteren bevorzugten Weiterbildung der vorliegenden Erfindung wird das Ausgangssignal zu dem Umschaltzeitpunkt, nach einem Verstreichen einer Verzögerungszeitdauer nach dem Einschaltzeitpunkt, wenn der erste Spannungspegel des Eingangsspannungssignals den Einschaltschwellwert überschritten hat, umgeschaltet.

In vorteilhafter Weise nimmt ein Eingangsstrom in die Schaltungsanordnung währen der Verzögerungsdauer, von dem Einschaltzeitpunkt bis zu dem Umschaltzeitpunkt, einen höheren Stromwert als nach dem Umschaltzeitpunkt an.

Auf diese Weise wird es durch die erfindungsgemäße elektronische Schaltungsanordnung zur Konvertierung eines Eingangsspannungssignals in ein Ausgangssignal und durch das entsprechende Konvertierungsverfahren ermöglicht, einen Einschaltzeitpunkt präzise ohne den Einfluss von Störungen festzulegen, wobei eine Erhöhung einer Verlustleistung vermieden wird.

### KURZE BESCHREIBUNG DER ZEICHNUNGEN

Ausführungsbeispiele der Erfindung sind in den Zeichnungen dargestellt und in der nachfolgenden Beschreibung näher erläutert.

In den Zeichnungen zeigen:
- Fig. 1: ein Blockdiagramm einer elektronischen Schaltungs- anordnung zur Konvertierung eines Eingangsspan- nungssignals in ein Ausgangssignal gemäß einer be- vorzugten Ausführungsform der vorliegenden Erfin- dung; und
- Fig. 2: ein Ablaufdiagramm zur Darstellung von Eingangssig- nalen und Ausgangssignalen betreffend die in Fig. 1 gezeigte Schaltungsanordnung, gemäß einem bevorzug- ten Ausführungsbeispiel der vorliegenden Erfindung.

In den Figuren bezeichnen gleiche Bezugszeichen gleiche oder funktionsgleiche Komponenten oder Schritte.

### WEGE ZUR AUSFÜHRUNG DER ERFINDUNG

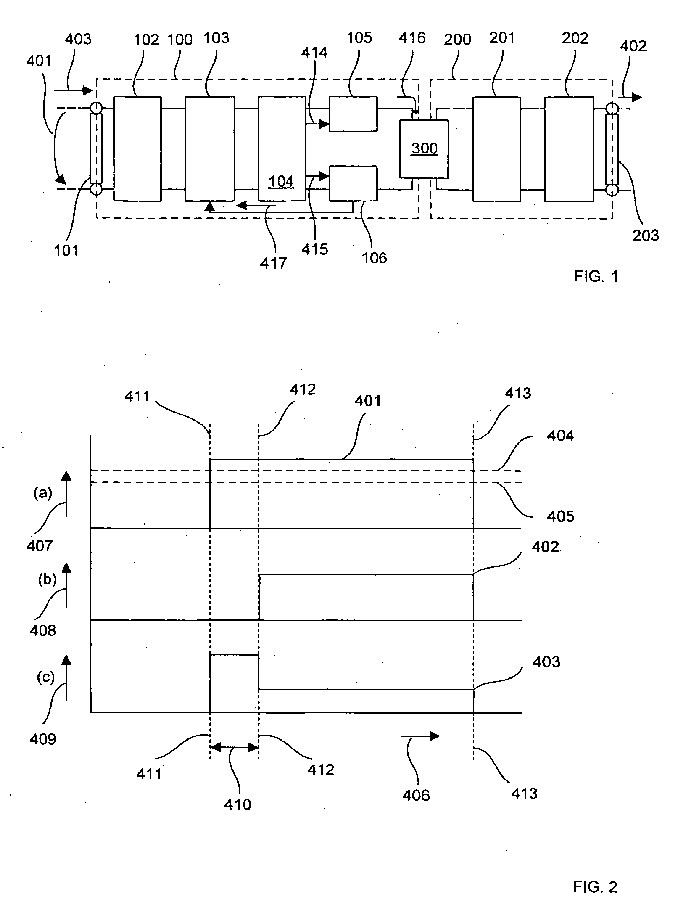

Fig. 1 zeigt ein schematisches Blockbild einer elektronischen Schaltungsanordnung zur Konvertierung eines Eingangsspannungssignals in ein Ausgangssignal gemäß einem bevorzugten Ausführungsbeispiel der vorliegenden Erfindung. Wie in Fig. 1 gezeigt, ist eine primärseitige Schaltungseinrichtung 100 mit einer sekundärseitigen Schaltungseinrichtung 200 über eine Kopplereinrichtung 300 verbunden.

Die Kopplereinrichtung 300 kann als ein Optokoppler oder als ein GMR-Koppler (Giant Magnetic Resistance, Magnetwiderstandskoppler) ausgebildet sein. An die primärseitige Schaltungseinrichtung 100 wird ein zu verarbeitendes Eingangsspannungssignal 401 angelegt, welches zu einem Eingangsstrom 403 in die Schaltungsanordnung führt. Zur Eingabe des Eingangsspannungssignals 401 und des Eingangsstroms 403 dient eine Eingabeeinheit 101.

Die Eingangssignale werden zunächst einer primärseitigen Filtereinheit 102 zugeführt, in welcher grobe Störungen des Eingangsspannungssignals herausgefiltert werden. Ein wesentliches Element der erfindungsgemäßen elektronischen Schaltungsanordnung ist eine mit dem Bezugszeichen 103 bezeichnete Eingangsimpedanz-Umschalteinheit. Der Eingangsimpedanz-Umschalteinheit wird ein Umschaltsignal 417 von einer untenstehend zu beschreibenden Auslöseeinheit 106 zugeführt.

Entsprechend dem Umschaltsignal 417 erfolgt in der Eingangsimpedanz-Umschalteinheit 103 eine Umschaltung der Eingangsimpedanz der elektronischen Schaltungsanordnung, d. h. einer Eingangsimpedanz, die bei der Eingabe eines Eingangsspannungssignals 401 bzw. eines Eingangsstroms 403 in die Eingabeeinheit 101 gesehen wird, von einem niedrigen Eingangsimpedanzwert zu einem hohen Eingangsimpedanzwert und umgekehrt.

Es sei darauf hingewiesen, dass ein niedriger Eingangsimpedanzwert dann erforderlich ist, wenn ein Pegelwechsel eines Eingangsspannungssignals mit möglichst geringem Einfluss externer Störungen erfasst werden soll, während ein hoher Wert der Eingangsimpedanz dann erforderlich ist, wenn der in die Schaltungsanordnung fließende Eingangsstrom 403 begrenzt werden soll und damit eine übermäßige Verlustleistung vermieden werden soll.

Der Eingangsimpedanz-Umschalteinheit 103 nachgeschaltet ist eine Schwellwertvergleichseinheit 104. Wie untenstehend unter Bezugnahme auf Fig. 2(a) erläutert werden wird, erfolgt in der Schwellwertvergleichseinheit 104 ein Vergleich des Eingangsspannungssignals 401 sowohl mit einem Einschaltschwellwert 404 bei einem Einschalten des Ausgangssignals 402 als auch mit einem Ausschaltschwellwert 405 bei einem Ausschalten des Ausgangssignals 402.

Über ein Stromquellen-Steuersignal wird eine der Schwellwertvergleichseinheit 104 nachgeschaltete Stromquelle 105 gesteuert, welche einen Strom als ein Übertragungssignal 416 der Kopplereinrichtung 300 zuführt. Weiterhin ist der Schwellwertvergleichseinheit 104 die Auslöseeinheit 106 nachgeschaltet, die von der Schwellwertvergleichseinheit 104 über ein Auslöseeinheit-Steuersignal 415 angesprochen wird. Die Einschaltvorgänge, Umschaltvorgänge und Ausschaltvorgänge sowie die entsprechenden Verzögerungszeiten werden untenstehend auf die Figuren 2(a), 2(b) und 2(c) erläutert.

Die in Fig. 1 gezeigte sekundärseitige Schaltungseinrichtung 200 weist eine sekundärseitige Filtereinheit 201 zur Filterung des aus der Kopplereinrichtung 300 ausgegebenen elektrischen Signals und eine Steuereinheit 202 auf. Die Steuereinheit 202 verarbeitet das über die Kopplereinrichtung 200 von der primärseitigen Schaltungseinrichtung 100 erhaltene Signal und gibt über eine Ausgabeeinheit 203 ein Ausgangssignal 402 aus, welches untenstehend in Fig. 2(b) veranschaulicht ist.

Unter Bezugnahme auf die Figuren 2(a), 2(b) und 2(c) wird nun die Funktion der elektronischen Schaltungsanordnung zur Konvertierung eines Eingangsspannungssignals eines ersten Spannungspegels in ein Ausgangssignal eines zweiten Spannungspegels erläutert. Fig. 2 veranschaulicht insgesamt ein Zeitablaufdiagramm, wobei zeitlich korreliert untereinander Verläufe über einer Zeit 406 eines Eingangsspannungswerts 407, eines Ausgangsspannungswerts 408 und eines Eingangsstromwerts 409 dargestellt sind.

Fig. 2(a) zeigt den Eingangsspannungswert 407 als Funktion der Zeit 406, wobei in Fig. 2(a) gleichzeitig die oben erwähnten Einschalt- und Ausschaltschwellwerte 404 und 405 eingezeichnet sind (gestrichelte horizontale Linien).

Es sei darauf hingewiesen, dass die in Fig. 2(a)-(c) gezeigten Spannungs- und Stromverläufe lediglich ein Beispiel zum Erläutern des grundlegenden Funktionsprinzips der vorliegenden Erfindung sind.

Zu einem mit dem Bezugszeichen 411 bezeichneten Einschaltzeitpunkt erfolgt ein Übergang des Eingangsspannungssignals von einem Null-Pegel auf einen ersten Spannungspegel.

Dieser Übergang von einem Null-Pegel auf den ersten Spannungspegel in dem Eingangsspannungssignal 401 soll bewirken, dass das Ausgangssignal 402 (siehe Fig. 2(b)) ebenfalls von einem Null-Pegel auf einen zweiten Spannungspegel ansteigt. Wie in der Fig. 2 ersichtlich, erfolgt ein derartiger Anstieg jedoch erst nach einer in der Schwellwertvergleichseinheit 104 einstellbaren Verzögerungszeitdauer 410. Die Verzögerungszeitdauer 410 ist der zeitliche Abstand zwischen einem Umschaltzeitpunkt 412 und dem Einschaltzeitpunkt 411. Wie obenstehend unter Bezugnahme auf Fig. 1 gezeigt, stellt die Auslöseeinheit 106 eine Rückkopplung zu der Schwellwertvergleichseinheit 104 bereit, derart, dass dieser das Umschaltsignal 417 zugeführt wird.

Während die Eingangsimpedanz-Umschalteinheit 103 zum Einschaltzeitpunkt 410 einen niedrigen Eingangsimpedanzwert aufweist, wird dieser zum Umschaltzeitpunkt 412 auf einen hohen Eingangsimpedanzwert umgeschaltet. Die Schwellwertvergleichseinheit 104 steuert über das Stromquellen-Steuersignal die Stromquelle 105 an, die dazu führt, dass ein Übertragungssignal 416 durch die Kopplereinrichtung 300 gesendet wird, welches dann sekundärseitig zu einem Anstieg, von einem Null-Pegel auf den zweiten Spannungspegel, des Ausgangssignals 402 führt.

Die Folge ist, dass, wie in Fig. 2(b) gezeigt, das Ausgangssignal 402 erst nach einer Verzögerungszeitdauer 410 nach dem Einschaltzeitpunkt 411 dem Spannungsverlauf des Eingangsspannungssignals 401 folgt. Der wesentliche Vorteil eines derartigen Umschaltverfahrens besteht darin, dass während der Verzögerungszeitdauer 410 Störungen, die an beispielsweise der Eingabeeinheit 101 der elektronischen Schaltungsanordnung anliegen, keinen Einfluss auf den Umschaltzeitpunkt aufweisen.

Die Ursache dafür liegt in der Tatsache, dass die elektronische Schaltungsanordnung in der Zeit zwischen dem Einschaltzeitpunkt 411 und dem Umschaltzeitpunkt 412 einen niedrigen Wert der Eingangsimpedanz aufweist, wobei, wie in dem unteren Verlauf der Fig. 2, d. h. in Fig. 2(c) gezeigt, hier ein hoher Eingangsstrom 403 in die Schaltungsanordnung fließt.

Dieser hohe Eingangsstrom 403 wird zum Umschaltzeitpunkt 412 in einen niedrigen Strom (typischerweise 1 mA) abgesenkt, so dass die Verlustleistung der Schaltungsanordnung einen zulässigen Maximalwert nicht überschreiten kann.

Ferner ist in den Figuren 2(a)-(c) ein Ausschaltzeitpunkt 413 gezeigt, welcher das Ausschalten des Eingangsspannungssignals 401 von dem ersten Spannungspegel auf den Null-Pegel repräsentiert. Es sei darauf hingewiesen, dass zu dem Ausschaltzeitpunkt die Eingangsimpedanz der elektronischen Schaltungsanordnung einen hohen Wert annimmt, da bereits zu dem Umschaltzeitpunkt 412 von einem hohen Eingangsimpedanzwert auf einen niedrigen Eingangsimpedanzwert umgeschaltet wurde. Dies ist jedoch im Hinblick auf die Eingangsstörungen unerheblich, da bei einem Ausschalten des Eingangsspannungssignals 401 ohnehin ein niederohmiger Abschluss der Eingabeeinheit 101 bereitgestellt wird.

Somit ist es möglich, ein Einschalten eines Eingangsspannungssignals 401 ohne Störungen mit großer Zuverlässigkeit zu erfassen, ohne dass die Verlustleistung der gesamten elektronischen Schaltungsanordnung übermäßig erhöht wird.

Vorzugsweise enthält die Eingangsimpedanz-Umschalteinheit Feldeffekttransistoren (FET), die bei einem Steuerstrom leitend werden. Der in Fig. 2(c) gezeigte Spitzenwert des Eingangsstroms 403 während der Verzögerungszeitdauer 410 kann einige Ampere betragen, während der Stromwert des übrigen Eingangstromverlaufs 403 lediglich einige Milliampere (mA) beträgt.

Obwohl die vorliegende Erfindung vorstehend anhand bevorzugter Ausführungsbeispiele beschrieben wurde, ist sie darauf nicht beschränkt, sondern auf vielfältige Weise modifizierbar.

Auch ist die Erfindung nicht auf die genannten Anwendungsmöglichkeiten beschränkt.

### BEZUGSZEICHENLISTE

In den Figuren bezeichnen gleiche Bezugszeichen gleiche oder funktionsgleiche Komponenten oder Schritte.
- 100: Primärseitige Schaltungseinrichtung
- 101: Eingabeeinheit
- 102: Primärseitige Filtereinheit
- 103: Eingangsimpedanz-Umschalteinheit
- 104: Schwellwertvergleichseinheit
- 105: Stromquelle
- 106: Auslöseeinheit
- 200: Sekundärseitige Schaltungseinrichtung
- 201: Sekundärseitige Filtereinheit
- 202: Steuereinheit
- 203: Ausgabeeinheit
- 300: Kopplereinrichtung
- 401: Eingangsspannungssignal
- 402: Ausgangssignal
- 403: Eingangsstrom
- 404: Einschaltschwellwert
- 405: Ausschaltschwellwert
- 406: Zeit
- 407: Eingangsspannungswert
- 408: Ausgangsspannungswert
- 409: Eingangsstromwert
- 410: Verzögerungszeitdauer
- 411: Einschaltzeitpunkt
- 412: Umschaltzeitpunkt
- 413: Ausschaltzeitpunkt
- 414: Stromquellen-Steuersignal
- 415: Auslöseeinheit-Steuersignal
- 416: Übertragungssignal
- 417: Umschaltsignal

## Patentansprüche

1. Elektronische Schaltungsanordnung zur Konvertierung eines Eingangsspannungssignals (401) eines ersten Spannungspegels in ein Ausgangssignal (402) eines zweiten Spannungspegels, mit:
a) einer Eingabeeinheit (101) zum Eingeben des Eingangsspannungssignals (401) bei dem ersten Spannungspegel;
b) einer Schwellwertvergleichseinheit (104) zum Vergleichen des ersten Spannungspegels des Eingangsspannungssignals (101) mit einem Einschaltschwellwert (404); und
c) einer Ausgabeeinheit (203) zur Ausgabe des Ausgangssignals (402) in Abhängigkeit von dem Vergleich des ersten Spannungspegels des Eingangsspannungssignals (101) mit dem Einschaltschwellwert (404),
**dadurch gekennzeichnet,**
**dass** die Schaltungsanordnung ferner aufweist:
d) eine Eingangsimpedanz-Umschalteinheit (103) zur Umschaltung einer Eingangsimpedanz der Schaltungsanordnung von einem niedrigen Wert auf einen hohen Wert nach einer vorbestimmten Verzögerungszeitdauer (411) nach einem Zeitpunkt (410), zu welchem der erste Spannungspegel des Eingangsspannungssignals (101) den Einschaltschwellwert (404) überschritten hat.

2. Schaltungsanordnung nach Anspruch 1,
**dadurch gekennzeichnet,**
**dass** eine Auslöseeinheit (106) bereitgestellt ist, die ein Umschaltsignal (417) zur Umschaltung der Eingangsimpedanz der Schaltungsanordnung von einem niedrigen Wert auf einen hohen Wert nach einer vorbestimmten Verzögerungszeitdauer (411) nach einer vorbestimmten Verzögerungszeitdauer (410) der Eingangsimpedanz-Umschalteinheit (103) zuführt.

3. Schaltungsanordnung nach Anspruch 1,
**dadurch gekennzeichnet,**
**dass** eine primärseitige Schaltungseinrichtung (100) und eine sekundärseitige Schaltungseinrichtung (200) bereitgestellt sind, welche über eine Kopplereinrichtung (300) gekoppelt sind.

4. Schaltungsanordnung nach Anspruch 3,
**dadurch gekennzeichnet,**
**dass** die Kopplereinrichtung (300) als ein Optokoppler ausgebildet ist.

5. Schaltungsanordnung nach Anspruch 3,
**dadurch gekennzeichnet,**
**dass** die Kopplereinrichtung (300) als ein magnetischer Koppler ausgebildet ist.

6. Schaltungsanordnung nach Anspruch 1,
**dadurch gekennzeichnet,**
**dass** die Schwellwertvergleichseinheit (104) eine Schalthysterese aufweist.

7. Verfahren zum Konvertieren eines Eingangsspannungssignals (401) eines ersten Spannungspegels in ein Ausgangssignal (402) eines zweiten Spannungspegels, mit den folgenden Schritten:
a) Eingeben des Eingangsspannungssignals (401) bei dem ersten Spannungspegel mittels einer Eingabeeinheit (101);
b) Vergleichen des ersten Spannungspegels des Eingangsspannungssignals (101) mit einem Einschaltschwellwert (404) mittels einer Schwellwertvergleichseinheit (104); und
c) Ausgeben des Ausgangssignals (402) in Abhängigkeit von dem Vergleich des ersten Spannungspegels des Eingangsspannungssignals (101) mit dem Einschaltschwellwert (404) mittels einer Ausgabeeinheit (203),
**dadurch gekennzeichnet,**
**dass** das Verfahren den folgenden Schritt aufweist:
d) Umschalten einer Eingangsimpedanz der Schaltungsanordnung von einem niedrigen Wert auf einen hohen Wert nach einer vorbestimmten Verzögerungszeitdauer (411) nach einem Zeitpunkt (410), zu welchem der erste Spannungspegel des Eingangsspannungssignals (101) den Einschaltschwellwert (404) überschritten hat.

8. Verfahren nach Anspruch 7,
**dadurch gekennzeichnet,**
**dass** die Eingangsimpedanz der Schaltungsanordnung einen niedrigen Wert aufweist, solange der erste Spannungspegel des Eingangsspannungssignals (401) kleiner als der Einschaltschwellwert ist.

9. Verfahren nach Anspruch 7,
**dadurch gekennzeichnet,**
**dass** die Eingangsimpedanz der Schaltungsanordnung einen hohen Wert aufweist, wenn der erste Spannungspegel des Eingangsspannungssignals (401) den Einschaltschwellwert überschreitet.

10. Verfahren nach Anspruch 7,
**dadurch gekennzeichnet,**
**dass** die Eingangsimpedanz-Umschalteinheit (103) die Eingangsimpedanz der Schaltungsanordnung von einem niedrigen Wert auf einen hohen Wert zu einem Umschaltzeitpunkt (412), wenn der erste Spannungspegel des Eingangsspannungssignals (101) den Einschaltschwellwert (404) überschritten hat, umschaltet.

11. Verfahren nach Anspruch 7,
**dadurch gekennzeichnet,**
**dass** die Eingangsimpedanz der Schaltungsanordnung von einem hohen Wert auf einen niedrigen Wert zu einem Umschaltzeitpunkt (412), nach einem Verstreichen einer Verzögerungszeitdauer (410) nach dem Einschaltzeitpunkt (411), wenn der erste Spannungspegel des Eingangsspannungssignals (101) den Einschaltschwellwert (404) überschritten hat, umgeschaltet wird.

12. Verfahren nach Anspruch 7,
**dadurch gekennzeichnet,**
**dass** das Ausgangssignal (402) zu dem Umschaltzeitpunkt (412), nach einem Verstreichen einer Verzögerungszeitdauer (410) nach dem Einschaltzeitpunkt (411), zu welchem der erste Spannungspegel des Eingangsspannungssignals (101) den Einschaltschwellwert (404) überschreitet, umgeschaltet wird.

13. Verfahren nach Anspruch 7,
**dadurch gekennzeichnet,**
**dass** ein Eingangsstrom (403) in die Schaltungsanordnung während der Verzögerungszeitdauer (411), von dem Einschaltzeitpunkt (411) bis zu dem Umschaltzeitpunkt (412), einen höheren Stromwert als nach dem Umschaltzeitpunkt (412) annimmt.

## Claims

1. Electronic circuit arrangement for converting an input voltage signal (401) having a first voltage level into an output signal (402) having a second voltage level, comprising:
a) an input unit (101) for inputting the input voltage signal (401) at the first voltage level;
b) a threshold value comparison unit (104) for comparing the first voltage level of the input voltage signal (401) with a switch-on threshold value (404); and
c) an output unit (203) for outputting the output signal (402) depending on the comparison of the first voltage level of the input voltage signal (401) with the switch-on threshold value (404),
**characterized**
**in that** the circuit arrangement furthermore has:
d) an input impedance changeover unit (103) for changing over an input impedance of the circuit arrangement from a low value to a high value after a predetermined delay time duration (410) after an instant (411) at which the first voltage level of the input voltage signal (401) exceeded the switch-on threshold value (404).

2. Circuit arrangement according to Claim 1,
**characterized**
**in that** a triggering unit (106) is provided, which feeds a changeover signal (417) for changing over the input impedance of the circuit arrangement from a low value to a high value after a predetermined delay time duration (410) to the input impedance changeover unit (103).

3. Circuit arrangement according to Claim 1,
**characterized**
**in that** a primary-side circuit device (100) and a secondary-side circuit device (200) are provided, which are coupled via a coupler device (300).

4. Circuit arrangement according to Claim 3,
**characterized**
**in that** the coupler device (300) is formed as an optocoupler.

5. Circuit arrangement according to Claim 3,
**characterized**
**in that** the coupler device (300) is formed as a magnetic coupler.

6. Circuit arrangement according to Claim 1,
**characterized**
**in that** the threshold value comparison unit (104) has a switching hysteresis.

7. Method for converting an input voltage signal (401) having a first voltage level into an output signal (402) having a second voltage level, comprising the following steps:
a) inputting of the input voltage signal (401) at the first voltage level by means of an input unit (101);
b) comparison of the first voltage level of the input voltage signal (401) with a switch-on threshold value (404) by means of a threshold value comparison unit (104); and
c) outputting of the output signal (402) depending on the comparison of the first voltage level of the input voltage signal (401) with the switch-on threshold value (404) by means of an output unit (203),
**characterized**
**in that** the method has the following step:
d) changeover of an input impedance of the circuit arrangement from a low value to a high value after a predetermined delay time duration (410) after an instant (411) at which the first voltage level of the input voltage signal (401) exceeded the switch-on threshold value (404).

8. Method according to Claim 7,
**characterized**
**in that** the input impedance of the circuit arrangement has a low value as long as the first voltage level of the input voltage signal (401) is less than the switch-on threshold value.

9. Method according to Claim 7,
**characterized**
**in that** the input impedance of the circuit arrangement has a high value if the first voltage level of the input voltage signal (401) exceeds the switch-on threshold value.

10. Method according to Claim 7,
**characterized**
**in that** the input impedance changeover unit (103) changes over the input impedance of the circuit arrangement from a low value to a high value at a changeover instant (412) if the first voltage level of the input voltage signal (401) exceeded the switch-on threshold value (404).

11. Method according to Claim 7,
**characterized**
**in that** the input impedance of the circuit arrangement is changed over from a high value to a low value at a changeover instant (412), after a delay time duration (410) has elapsed after the switch-on instant (411), if the first voltage level of the input voltage signal (401) exceeded the switch-on threshold value (404).

12. Method according to Claim 7,
**characterized**
**in that** the output signal (402) is changed over at the changeover instant (412), after a delay time duration (410) has elapsed after the switch-on instant (411) at which the first voltage level of the input voltage signal (401) exceeds the switch-on threshold value (404).

13. Method according to Claim 7,
**characterized**
**in that** an input current (403) into the circuit arrangement assumes a higher current value during the delay time duration (410), from the switch-on instant (411) to the changeover instant (412), than after the changeover instant (412).

## Revendications

1. Arrangement de circuit électronique pour convertir un signal de tension d'entrée (401) d'un premier niveau de tension en un signal de sortie (402) d'un deuxième niveau de tension, comprenant :
a) une unité d'entrée (101) pour l'entrée du signal de tension d'entrée (401) au premier niveau de tension ;
b) une unité de comparaison de valeur de seuil (104) pour comparer le premier niveau de tension du signal de tension d'entrée (401) avec une valeur de seuil de mise en marche (404) ; et
c) une unité de délivrance (203) pour délivrer le signal de sortie (402) en fonction de la comparaison du premier niveau de tension du signal de tension d'entrée (401) avec la valeur de seuil de mise en marche (404),
**caractérisé en ce**
**que** l'arrangement de circuit présente en outre : d) une unité de permutation d'impédance d'entrée (103) pour permuter une impédance d'entrée de l'arrangement de circuit d'une valeur faible à une valeur élevée après un temps de retard prédéfini (410) après un instant (411) auquel le premier niveau de tension du signal de tension d'entrée (401) a dépassé la valeur de seuil de mise en marche (404).

2. Arrangement de circuit selon la revendication 1, **caractérisé en ce qu'**il existe une unité de déclenchement (106) qui achemine à l'unité de permutation d'impédance d'entrée (103) un signal de permutation (417) pour permuter l'impédance d'entrée de l'arrangement de circuit d'une valeur faible à une valeur élevée après temps de retard prédéfini (410).

3. Arrangement de circuit selon la revendication 1, **caractérisé en ce qu'**il existe un dispositif de commutation côté primaire (100) et un dispositif de commutation côté secondaire (200), lesquels sont accouplés par le biais d'un dispositif de couplage (300).

4. Arrangement de circuit selon la revendication 3, **caractérisé en ce que** le dispositif de couplage (300) est réalisé sous la forme d'un optocoupleur.

5. Arrangement de circuit selon la revendication 3, **caractérisé en ce que** le dispositif de couplage (300) est réalisé sous la forme d'un coupleur magnétique.

6. Arrangement de circuit selon la revendication 1, **caractérisé en ce que** l'unité de comparaison de valeur de seuil (104) présente une hystérésis de comparaison.

7. Procédé de conversion d'un signal de tension d'entrée (401) d'un premier niveau de tension en un signal de sortie (402) d'un deuxième niveau de tension, comprenant les étapes suivantes :
a) entrée du signal de tension d'entrée (401) au premier niveau de tension au moyen d'une unité d'entrée (101) ;
b) comparaison du premier niveau de tension du signal de tension d'entrée (401) avec une valeur de seuil de mise en marche (404) au moyen d'une unité de comparaison de valeur de seuil (104) ; et
c) délivrance du signal de sortie (402) en fonction de la comparaison du premier niveau de tension du signal de tension d'entrée (401) avec la valeur de seuil de mise en marche (404) au moyen d'une unité de délivrance (203),
**caractérisé en ce**
**que** le procédé présente les étapes suivantes :
d) permutation d'une impédance d'entrée de l'arrangement de circuit d'une valeur faible à une valeur élevée après un temps de retard prédéfini (410) après un instant (411) auquel le premier niveau de tension du signal de tension d'entrée (401) a dépassé la valeur de seuil de mise en marche (404).

8. Procédé selon la revendication 7, **caractérisé en ce que** l'impédance d'entrée de l'arrangement de circuit présente une valeur faible tant que le premier niveau de tension du signal de tension d'entrée (401) est inférieur à la valeur de seuil de mise en marche.

9. Procédé selon la revendication 7, **caractérisé en ce que** l'impédance d'entrée de l'arrangement de circuit présente une valeur élevée lorsque le premier niveau de tension du signal de tension d'entrée (401) dépasse la valeur de seuil de mise en marche.

10. Procédé selon la revendication 7, **caractérisé en ce que** l'unité de permutation d'impédance d'entrée (103) permute l'impédance d'entrée de l'arrangement de circuit d'une valeur faible à une valeur élevée à un instant de permutation (412) lorsque le premier niveau de tension du signal de tension d'entrée (401) a dépassé la valeur de seuil de mise en marche (404).

11. Procédé selon la revendication 7, **caractérisé en ce que** l'impédance d'entrée de l'arrangement de circuit est permutée d'une valeur élevée à une valeur faible à un instant de permutation (412) après l'écoulement d'un temps de retard (410) après l'instant de mise en marche (411), lorsque le premier niveau de tension du signal de tension d'entrée (401) a dépassé la valeur de seuil de mise en marche (404).

12. Procédé selon la revendication 7, **caractérisé en ce que** le signal de sortie (402) est permuté à l'instant de permutation (412), après l'écoulement d'un temps de retard (410) après l'instant de mise en marche (411), auquel le premier niveau de tension du signal de tension d'entrée (401) dépasse la valeur de seuil de mise en marche (404).

13. Procédé selon la revendication 7, **caractérisé en ce qu'**un courant d'entrée (403) dans l'arrangement de circuit prend une valeur de courant plus élevée pendant le temps de retard (410) entre l'instant de mise en marche (411) et l'instant de permutation (412) qu'après l'instant de permutation (412).
